## Europäisches Patentamt

**European Patent Office**

**Office européen des brevets**

(19)

(11) Veröffentlichungsnummer : **0 384 938 B1**

(12) **EUROPÄISCHE PATENTSCHRIFT**

(45) Veröffentlichungstag der Patentschrift :
**30.11.94 Patentblatt 94/48**

(51) Int. Cl.$^5$ : **H03L 5/00**, H03K 3/01,
H03K 3/03

(21) Anmeldenummer : **89103800.2**

(22) Anmeldetag : **03.03.89**

(54) **Integrierbare amplitudengeregelte Oszillatorschaltung.**

(43) Veröffentlichungstag der Anmeldung :
**05.09.90 Patentblatt 90/36**

(45) Bekanntmachung des Hinweises auf die
Patenterteilung :
**30.11.94 Patentblatt 94/48**

(84) Benannte Vertragsstaaten :
**DE FR GB IT NL**

(56) Entgegenhaltungen :
**EP-A- 0 050 583**
**EP-A- 0 299 215**

(56) Entgegenhaltungen :
**DE-A- 3 223 338**
**IEEE JOURNAL OF SOLID-STATE CIRCUITS,
Band 23, Nr. 3, Juni 1988, Seiten 774-783, IEEE,
New York, US; E.A. VITTOZ et al.:
"High-performance crystal oscillator circuits:
Theory and application"**

(73) Patentinhaber : **SIEMENS
AKTIENGESELLSCHAFT
Wittelsbacherplatz 2
D-80333 München (DE)**

(72) Erfinder : **Koch, Rudolf, Dr.-Ing.
Goerdelerstrasse 18
D-8025 Unterhaching (DE)**

EP 0 384 938 B1

**Beschreibung**

Die Erfindung betrifft eine integrierbare amplitudengeregelte Oszillatorschaltung nach dem Oberbegriff des Patentanspruches 1.

Integrierte Schaltkreise benötigen für ihre Funktion häufig einen Takt, der üblicherweise in einer Oszillatorschaltung erzeugt wird, die aus einem integrierten Verstärker sowie einem Schwingelement, meist einem Schwingquarz und Lastkapazitäten besteht. Der im folgenden als Inverter bezeichnete integrierte Verstärker ist im allgemeinen nach dem Prinzip des Pierce-Oszillators beschaltet. An diesen Oszillator werden nun widersprüchliche Anforderungen gestellt. Einerseits soll auch unter ungünstigen Bedingungen (niedrige Versorgungsspannung, hohe Temperatur, Quarz relativ geringer Güte, hohe Lastkapazität) ein rasches Anschwingen gewährleistet sein, wozu ein verhältnismäßig hoher Strom und eine hohe Steilheit der Schaltung benötigt werden. Andererseits soll im eingeschwungenen Zustand der Schaltung auch unter an sich günstigen Bedingungen (hohe Versorgungsspannung, Quarz hoher Güte) die Schwingungsamplitude nicht unter bzw. über die Versorgungsspannung hinausgehen, da sonst die Leistungsaufnahme unnötig hoch wird und darüber hinaus durch Ladungsträgerinjektion in das Substrat Störungen in der integrierten Schaltung verursacht werden können. Dafür sind nur geringe Ströme und Steilheiten zulässig.

Bei zahlreichen Schaltungen ist der Oszillator nur auf Anschwingsicherheit dimensioniert und die obengenannten Beeinträchtigungen im eingeschwungenen Zustand werden in Kauf genommen. Insbesondere für Uhrenschaltkreise wurde daher ein in I.Vittoz et al, High-Performance Cristal Oscillator Circuits, IEEE J. Solid State Circuits, Vol. SC-23, No. 3, June 1988, Seiten 774 bis 783, beschriebener, geregelter Oszillator nach dem Prinzip des Pierce-Oszillators entwickelt, der mit hohem Strom und hoher Steilheit das Anschwingen sicherstellt und im eingeschwungenen Zustand mit reduziertem Strom die Schwingungsamplitude begrenzt. Bei dem beschriebenen Oszillator ist es erforderlich, daß wenigstens einige Transistoren im sog. Unterschwellenbereich arbeiten, d.h. mit sehr geringer Stromdichte. Während das für den hauptsächlich vorgesehenen Anwendungsbereich dieses Oszillators mit nur 32 KHz Oszillatorfrequenz möglich ist, treten bei hohen Schwingungsfrequenzen im MHz-Bereich Probleme auf. Für diese hohen Frequenzen sind wesentlich höhere Ströme und Steilheiten erforderlich, so daß ein Betrieb der Transistoren im Unterschwellenbereich wegen der dann nötigen großen Strukturen nicht mehr sinnvoll ist. Darüber hinaus ist der bekannte Oszillator empfindlich gegenüber Parameterschwankungen, wenn einzelne Transistoren, insbesondere in der Amplitudenregelstufe, nicht im Unterschwellenbereich betrieben werden. Ferner kann der eigentlichen Oszillatorschaltung über den sie speisenden Stromspiegel im Unterschwellenbereich nur ein begrenzter Strom zugeführt werden, der wesentlich niedriger ist als der in einem üblichen Inverter fließende Querstrom. Aus den genannten Gründen ist der bekannte Oszillator für Frequenzen im MHz-Bereich wegen der dann erforderlichen höheren Ströme weniger geeignet.

Ebenso ist aus der EP-A-0 299 215 eine Amplitudenregelschaltung gemäß dem Oberbegriff des Anspruchs 1 bekannt. Diese dient jedoch dazu die Komponenten des Eingangssignals, die unterhalb einer bestimmten Grenzfrequenz liegen durch die Gleichtaktunterdrückung eines Operationsverstärkers zu eliminieren.

Aufgabe der Erfindung ist es daher, eine Oszillatorschaltung mit Amplitudenregelung für höhere Frequenzen anzugeben.

Gelöst wird die vorstehend aufgezeigte Aufgabe bei einer gattungsgemäßen Oszillatorschaltung durch die kennzeichnenden Merkmale des Patentanspruches 1. Ausgestaltungen und Weiterbildungen des Erfindungsgedankens sind in Unteransprüchen gekennzeichnet.

Die Vorteile einer erfindungsgemäßen Oszillatorschaltung liegen darin, daß ein hoher Strom ein sicheres Anschwingen gewährleistet, während im eingeschwungenen Zustand auch bei hohen Frequenzen der Strom reduziert ist. Darüber hinaus ist es vorteilhaft, daß die Schwingungsamplitude unabhängig von allen Parameterschwankungen eingestellt werden kann.

Die Erfindung wird nachfolgend anhand von dem in den FIG der Zeichnung dargestellten Ausführungsbeispiel näher erläutert, wobei gleiche Elemente mit gleichen Bezugszeichen versehen sind. Es zeigt:

FIG 1      eine Ausführungsform einer gattungsgemäßen Oszillatorschaltung und

FIG 2      eine Ausführungsform einer Amplitudenregelschaltung gemäß der Erfindung bei einer Oszillatorschaltung nach FIG 1.

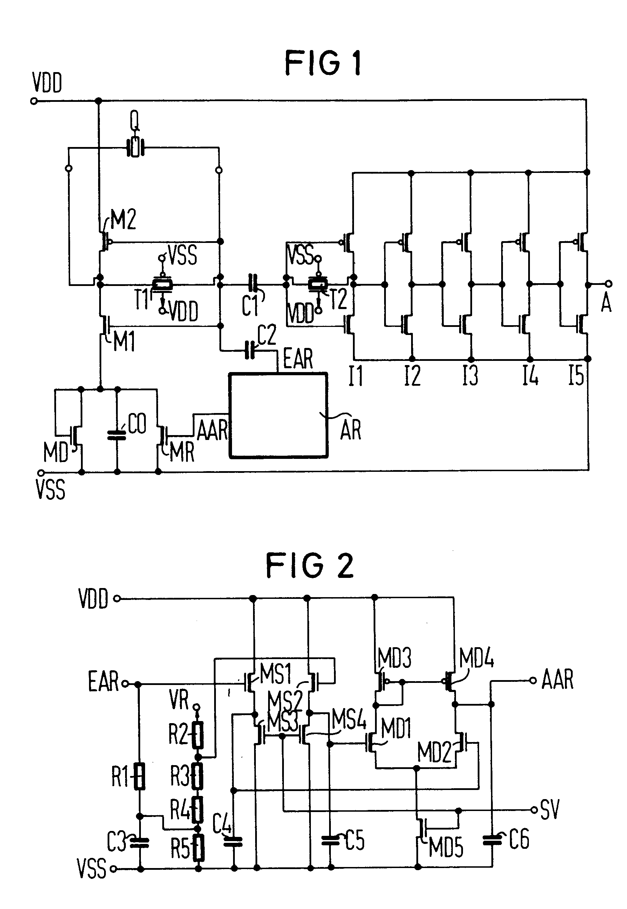

Bei der Oszillatorschaltung nach FIG 1 ist ein Inverter zwischen seinem Ausgang und seinem Eingang durch einen Schwingquarz (Q) als Schwingelement rückgekoppelt. Der Inverter besteht aus zwei komplementären MOS-Transistoren, nämlich einem NMOS-Transistor M1 und einem PMOS-Transistor M2, deren Gateanschlüsse den Eingang des Inverters bildend und deren Drainanschlüsse den Ausgang des Inverters bildend jeweils zusammengeschaltet sind. Zusätzlich enthält der Inverter eine Transmission-Gate-Stufe T1 mit zwei komplementären MOS-Transistoren, deren Source-Drain-Strecken dem Schwingquarz Q parallel liegen.

Der Gateanschluß des PMOS-Transistors der Transmission-Gate-Stufe T1 ist mit dem negativen Pol VSS und der Gateanschluß des NMOS-Transistors ist mit dem positiven Pol VDD einer in der Zeichnung nicht näher dargestellten Versorgungsspannungsquelle verbunden. An den positiven Pol VDD ist darüber hinaus der Sourceanschluß des Transistors M2 angeschlossen. Der Sourceanschluß des Transistors MI dagegen ist über die Source-Drain-Strecke eines weiteren NMOS-Transistors MR auf den negativen Pol VSS geführt. Der Source-Drain-Strecke des Transistors MR ist ein Kondensator CO sowie die Source-Drain-Strecke eines durch eine Verbindung von Gate- und Drain-Anschluß als Diode betriebener NMOS-Transistor MD parallelgeschaltet. Der Gateanschluß des Transistors MR ist mit dem Ausgang AAR einer Amplitudenregelschaltung AR verbunden, deren Eingang EAR über einen Kondensator C2 an den Eingang des Inverters angeschlossen ist. An den Eingang des Inverters ist zudem über einen Kondensator C1 eine auf einen Ausgang A führende Ausgangsstufe angekoppelt. Diese besteht aus fünf hintereinandergeschalteten, jeweils zwei komplementäre MOS-Transistoren aufweisenden Invertern I1 bis I5, wobei dem am Eingang der Ausgangsstufe angeordneten Inverter I1 ein Transmission-Gate T2 parallelgeschaltet ist.

Gemäß FIG 2 umfaßt die Amplitudenregelschaltung AR nach FIG 1 einen Differenzverstärker mit einem dem invertierenden Eingang vorgeschalteten ersten Spitzenwertgleichrichter und einem dem nicht invertierenden Eingang vorgeschalteten zweiten Spitzenwertgleichrichter. Der Differenzverstärker besteht aus zwei sourcegekoppelten NMOS-Transistoren MD1,MD2, deren Drainanschlüsse jeweils mit den Drainanschlüssen zweier, sourceseitig an dem positiven Pol VDD liegenden PMOS-Transistoren MD3 und MD4 in Stromspiegelschaltung verbunden sind. Die gekoppelten Sourceanschlüsse der Transistoren MD1 und MD2 sind über die Drain-Source-Strecke eines NMOS-Transistors MD5 auf den negativen Pol VSS geführt. Der Gateanschluß des Transistors MD5 ist mit einer gegenüber dem negativen Pol VSS positiven Ansteuerspannung SV beaufschlagt. Die beiden Spitzenwertgleichrichter sind identisch aus jeweils einem ersten Transistor, dessen Drainanschluß an den positiven Pol VDD angeschlossen ist, und einem zweiten Transistor, dessen Sourceanschluß an den negativen Pol VSS angeschlossen ist, aufgebaut, wobei der Sourceanschluß des ersten Transistors und der Drainanschluß des zweiten Transistors zusammengefaßt und mit einem auf den negativen Pol VSS führenden Glättungskondensator verschaltet sind. Der erste Spitzenwertgleichrichter weist dabei einen NMOS-Transistor MS1 als ersten Transistor, einen NMOS-Transistor MS3 als zweiten Transistor und einen Kondensator C4 als Glättungskondensator auf. Entsprechend bildet beim zweiten Spitzenwertgleichrichter ein NMOS-Transistor MS2 den ersten Transistor, ein NMOS-Transistor MS4 den zweiten Transistor und ein Kondensator C5 den Glättungskondensator. Die nicht am negativen Pol VSS liegenden Anschlüsse der Glättungskondensatoren sind, wie bereits beschrieben, jeweils mit einem der Eingänge des Differenzverstärkers verbunden. Die Gateanschlüsse des Transistors MS3 und des Transistors MS4 sind jeweils eine Stromeinprägung bildend mit Ansteuerspannung SV beaufschlagt. Die Ansteuerspannung SV kann ein den Temperaturgang der Transistoren MS3,MS4 und MD5 kompensierendes Verhalten aufweisen. Des weiteren umfaßt die Amplitudenregelschaltung AR zur Erzeugung von zwei Hilfspannungen einen Spannungsteiler mit von einem positiven Pol VR einer nicht näher dargestellten Referenzspannungsquelle aus zum negativen Pol VSS von Referenz- und Versorgungsspannungsquelle in Reihe geschalteten Widerständen R2,R3,R4 und R5. An den Abgriff zwischen dem Widerstand R2 und dem Widerstand R3 ist der Gateanschluß des Transistors MS2 geführt. Der den Eingang der Amplitudenregelschaltung AR bildende Gateanschluß des Transistors MS1 ist über einen Widerstand R1 an den Abgriff zwischen dem Widerstand R4 und dem Widerstand R5, dem ein Kondensator C3 parallelgeschaltet ist, gelegt. Schließlich ist der als Ausgang AAR der Amplitudenregelschaltung AR vorgesehene Ausgang des Differenzverstärkers mit einem Kondensator C6 auf den negativen Pol VSS geführt.

Nachdem zuvor der prinzipielle Aufbau der in den FIG der Zeichnung dargestellten erfindungsgemäßen Schaltungsanordnung erläutert worden ist, sei nunmehr auf deren Arbeitsweise näher eingegangen.

Der eigentliche Oszillator wird von dem aus den Transistoren M1 und M2 bestehenden Inverter gebildet. Der in den Transistoren M1 und M2 fließende mittlere Strom wird von der Amplitudenregelschaltung AR über den als Stellglied vorgesehenen Transistor MR eingestellt. Um ein vollständiges Zuregeln des Inverters vorteilhafterweise zu verhindern, liegt parallel zu dem Transistor MR der als Diode geschaltete Transistor MD. Der Kondensator C0 überbrückt in Ausgestaltung der Erfindung den Transistor MR für Wechselspannungen. Die Schwingung des Oszillators wird über den Kondensator C1 in eine Inverterkette mit den fünf hintereinandergeschalteten Invertern I1 bis I5 eingekoppelt, dort aufgeteilt und kann am Ausgang A als Rechtecksignal abgenommen werden. Der erste Inverter I1 wird bevorzugt kapazitiv angekoppelt, damit durch die Regelung bewirkte Arbeitspunktverschiebungen der Transistoren M1 und M2 sich nicht auf das Tastverhältnis des Rechteckimpulses am Ausgang A auswirken. Der Inverter des Oszillators weist in Ausgestaltung der Erfindung ein Transmission-Gate T1 zur Arbeitspunkteinstellung auf. Statt des Inverters mit den Transistoren M1,M2 kann auch, wie bei der bekannten Oszillatorschaltung beschrieben, ein einzelner, größerer PMOS-Transistor oder NMOS-Transistor mit steuerbarer Stromquelle im Drainzweig als Stellglied verwendet werden. In die Amplitudenregelschaltung AR wird die im wesentlichen sinusförmige Oszillatorschwingung über den Kondensator C2 ebenfalls kapazitiv eingekoppelt. Zunächst erfolgt mit den Transistoren MS1 und MS3 eine Spitzenwertgleichrichtung der Schwingung. Der Scheitelwert der Schwingung ist als Spannung U(C4) über dem Kondensator C4 verfügbar und ergibt sich formal zu

$$U(C4) = VR * R5 / (R2 + R3 + R4 + R5) - UGS(MS1) + US,$$

wobei US die Scheitelamplitude der Schwingung und UGS (MS1) die Gate-Source-Spannung des Transistors MS1 ist. Die Spannung U(C4) wird in dem aus den Transistoren MD1 bis MD5 gebildeten Differenzverstärker mit der Spannung U(C5) über dem Kondensator C5 verglichen, die sich berechnet zu

$$U(C5) = VR * (R3 + R4 + R5) / (R2 + R3 + R4 + R5) - UGS(MS2).$$

UGS(MS2) ist dabei die Gate-Source-Spannung des Transistors MS2. Der Differenzverstärker stellt die Gate-Source-Spannung des Transistors MR so ein, daß die Spannung U(C4) und U(C5) gleich werden. Aus Symmetriegründen ist im eingeregelten Zustand die Gate-Source-Spannung der Transistoren MS1 und MS2 gleich. Damit folgt

$$US = VR2 * (R3 + R4) / (R2 + R3 + R4 + R5).$$

Die Schwingungsamplitude wird damit unabhängig von Parameterschwankungen über die Referenzspannung VR - VSS und die Dimensionierung des zur Erzeugung der Hilfsspannungen vorgesehenen Spannungsteilers bestimmt. Mit dem Kondensator C6 wird der dominante Pol dem Regelkreises bestimmt, womit die Stabilität des Regelkreises erhöht wird. Für den Fall, daß die Versorgungsspannung ausreichend stabil vorliegt, besteht die Möglichkeit, den Spannungsteiler R2...R5 statt an eine Referenzspannung an die Versorgungsspannung zu legen.

**Patentansprüche**

1. Integrierbare amplitudengeregelte Oszillatorschaltung mit einem Inverter (M1, M2, T1), bei dem Ausgang und Eingang über ein Schwingelement (Q) miteinander gekoppelt sind und dessen Querstrom über ein Stellglied (MR) veränderbar ist, mit einer Amplitudenregelschaltung (AR), deren Eingang mit dem Eingang des Inverters (M1, M2, T1) und deren Ausgang mit dem Steuereingang des Stellgliedes (MR) verbunden ist, und mit einer Ausgangsstufe (I1 bis I5, T2), deren Eingang an den Eingang des Inverters (M1, M2, T1) angeschlossen ist,
**dadurch gekennzeichnet,**
daß als Amplitudenregelschaltung (AR) ein Differenzverstärker (MD1 bis MD5) mit einem dem invertierenden Eingang vorgeschalteten ersten Spitzenwertgleichrichter (MS1, MS3, C4) und mit einem dem nichtinvertierenden Eingang vorgeschalteten zweiten Spitzenwertgleichrichter (MS2, MS4, C5) vorgesehen ist,
daß der erste Spitzenwertgleichrichter (MS1, MS3, C4) mit der Summe (EAR) aus der am Eingang des Inverters (M1, M2, T1) anliegenden Signalspannung und einer aus einer Referenzgleichspannung (VR) abgeleiteten ersten Hilfsspannung beaufschlagt ist und daß der zweite Spitzenwertgleichrichter (MS2, MS4, C5) mit einer aus der Referenzspannung (VR) abgeleiteten zweiten Hilfsspannung beaufschlagt ist, wobei der Betrag der ersten Hilfsspannung kleiner als der der zweiten Hilfsspannung ist und das Ausgangssignal (AAR) der Amplitudenregelschaltung (AR) am Ausgang des Differenzverstärkers (MD1 bis MD5) abgreifbar ist.

2. Oszillatorschaltung nach Anspruch 1,
**dadurch gekennzeichnet,**
daß als Schwingelement ein Schwingquarz (Q) vorgesehen ist.

3. Oszillatorschaltung nach Anspruch 1 oder 2,
**dadurch gekennzeichnet,**
daß die Ausgangsstufe (I1 bis I5) über einen Kondensator (CI) an den Inverter (M1,M2,T1) angeschlossen ist.

4. Oszillatorschaltung nach einem der Ansprüche 1 bis 3,
**dadurch gekennzeichnet,**
daß der Inverter aus einem MOS-Transistor mit einer steuerbaren Stromquelle im Drainzweig als Stellglied aufgebaut ist.

5. Oszillatorschaltung nach einem der Ansprüche 1 bis 4,
**dadurch gekennzeichnet,**

daß der Inverter aus zwei komplementären MOS-Transistoren (M1,M2) in Gegentaktschaltung aufgebaut ist.

6. Oszillatorschaltung nach einem der Ansprüche 1 bis 5,
**dadurch gekennzeichnet,**
daß als Stellglied ein MOS-Transistor (MR) vorgesehen ist.

7. Oszillatorschaltung nach Anspruch 6,
**dadurch gekennzeichnet,**
daß dem MOS-Transistor des Stellglieds (MR) eine Diode (MD) in Durchlaßrichtung parallelgeschaltet ist.

8. Oszillatorschaltung nach Anspruch 6 oder 7,
**dadurch gekennzeichnet,**
daß dem MOS-Transistor des Stellglieds (MR) ein Kondensator (CO) parallelgeschaltet ist.

9. Oszillatorschaltung nach einem der Ansprüche 1 bis 8,
**dadurch gekennzeichnet,**
daß als Ausgangsstufe mindestens ein weiterer Inverter (I1 bis I5) vorgesehen ist.

10. Oszillatorschaltung nach einem der Ansprüche 1 bis 9,
**dadurch gekennzeichnet,**
daß dem Ausgang des Differenzverstärkers (MD1 bis MD5) ein Kondensator (C6) parallelgeschaltet ist.

11. Oszillatorschaltung nach einem der Ansprüche 1 bis 10,
**dadurch gekennzeichnet,**
daß die Amplitudenregelschaltung (AR) über einen Kondensator (C2) mit dem Inverter (M1,M2,T1) verbunden ist.

12. Oszillatorschaltung nach einem der Ansprüche 1 bis 11,
**dadurch gekennzeichnet,**
daß als Spitzenwertgleichrichter jeweils ein MOS-Transistor (MS1,MS2) mit Stromeinprägung (MS3,MS4) in Sourcefolgerschaltung vorgesehen ist, dem ein Glättungskondensator (C4,C5) nachgeschaltet ist.

13. Oszillatorschaltung nach einem der Ansprüche 1 bis 12,
**dadurch gekennzeichnet,**
daß erste und zweite Hilfsspannung mittels mindestens eines Spannungsteilers (R2,R3,R4,R5) aus der Referenzspannung (VR) erzeugt werden.

14. Oszillatorschaltung nach einem der Ansprüche 1 bis 13,
**dadurch gekennzeichnet,**
daß die beiden Spitzenwertgleichrichter (MS1,MS3,C4; MS2,MS4, C5) identisch ausgebildet sind.

## Claims

1. Amplitude-regulated oscillator circuit, which can be integrated, having an invertor (M1, M2, T1), in which output and input are coupled to one another via an oscillating element (Q) and whose quadrature-axis current can be adjusted by means of an actuator (MR), having an amplitude-regulating circuit (AR) whose input is connected to the input of the invertor (M1, M2, T1) and whose output is connected to the control input of the actuator (MR), and having an output stage (I1 to I5, T2) whose input is connected to the input of the invertor (M1, M2, T1), characterized in that as amplitude-regulating circuit (AR) a differential amplifier (MD1 to MD5) is provided having a first peak detector (MS1, MS3, C4) connected upstream of the inverting input and having a second peak detector (MS2, MS4, C5) connected upstream of the non-inverting input, in that the sum (EAR) of the signal voltage, which is present at the input of the invertor (M1, M2, T1), and a first auxiliary voltage which is derived from a reference DC voltage (VR) is applied to the first peak detector (MS1, MS3, C4), and in that a second auxiliary voltage which is derived from the reference voltage (VR) is applied to the second peak detector (MS2, MS4, C5), the absolute value of the first auxiliary voltage being smaller than that of the second auxiliary voltage and the output signal (AAR) of the amplitude-regulating circuit (AR) being able to be tapped at the output of the differential amplifier (MD1 to MD5).

2. Oscillator circuit according to Claim 1, characterized in that an oscillating crystal (Q) is provided as oscillating element.

3. Oscillator circuit according to Claim 1 or 2, characterized in that the output stage (I1 to I5) is connected to the invertor (M1, M2, T1) via a capacitor (C1).

4. Oscillator circuit according to one of Claims 1 to 3, characterized in that the invertor is constructed from an MOS transistor which has as actuator a controllable current source in the drain branch.

5. Oscillator circuit according to one of Claims 1 to 4, characterized in that the invertor is constructed from two complementary MOS transistors (M1, M2) in the form of a push-pull circuit.

6. Oscillator circuit according to one of Claims 1 to 5, characterized in that an MOS transistor (MR) is provided as actuator.

7. Oscillator circuit according to Claim 6, characterized in that a diode (MD) in the conducting direction is connected in parallel with the MOS transistor of the actuator (MR).

8. Oscillator circuit according to Claim 6 or 7, characterized in that a capacitor (CO) is connected in parallel with the MOS transistor of the actuator (MR).

9. Oscillator circuit according to one of Claims 1 to 8, characterized in that at least one further invertor (I1 to I5) is provided as output stage.

10. Oscillator circuit according to one of Claims 1 to 9, characterized in that a capacitor (C6) is connected in parallel with the output of the differential amplifier (MD1 to MD5).

11. Oscillator circuit according to one of Claims 1 to 10, characterized in that the amplitude-regulating circuit (AR) is connected to the invertor (M1, M2, T1) via a capacitor (C2).

12. Oscillator circuit according to one of Claims 1 to 11, characterized in that an MOS transistor (MS1, MS2), as a peak detector, is in each case provided with a constant current device (MS3, MS4) in the form of a source follower circuit, downstream of which transistor a smoothing capacitor (C4, C5) is connected.

13. Oscillator circuit according to one of Claims 1 to 12, characterized in that the first and second auxiliary voltage are generated from the reference voltage (VR) by means of at least one voltage divider (R2, R3, R4, R5).

14. Oscillator circuit according to one of Claims 1 to 13, characterized in that the two peak detectors (MS1, MS3, C4; MS2, MS4, C5) are constructed identically.

## Revendications

1. Circuit oscillateur intégrable réglé en amplitude, comportant un inverseur (M1,M2,T1) dont la sortie et l'entrée sont couplées entre elles par l'intermédiaire d'un élément oscillant (Q) et dont le courant transversal peut être modifié par l'intermédiaire d'un circuit de réglage (MR), comportant un circuit de régulation d'amplitude (AR), dont l'entrée est reliée à l'entrée de l'inverseur (M1,M2,T1) et dont la sortie est reliée à l'entrée de commande du circuit de réglage (MR), et comportant un étage de sortie (I1 à I5, T2), dont l'entrée est raccordée à l'entrée de l'inverseur (M1,M2,T1), caractérisé par le fait qu'il est prévu, comme circuit de régulation d'amplitude (AR), un amplificateur différentiel (MD1 à MD5) comportant un premier redresseur de valeurs crêtes (MS1,MS3,C4), branché en amont de l'entrée inverseuse, et un second redresseur de valeurs crêtes (MS2,MS4,C5) branché en amont de l'entrée non inverseuse,

que le premier redresseur de valeurs crêtes (MS1,MS3,C4) est chargé par la somme (EAR) de la tension de signal, qui est appliquée à l'entrée de l'inverseur (M1,M2,T1), et d'une première tension auxiliaire dérivée d'une tension continue de référence (VR), et que le second redresseur de valeurs crêtes (MS2,MS4,C5) est chargé par une seconde tension auxiliaire dérivée de la tension de référence (VR), la valeur absolue de la première tension de référence étant inférieure à la valeur absolue de la seconde tension de auxiliaire, tandis que le signal de sortie (AAR) du circuit de régulation d'amplitude (AR) peut être prélevé à la sortie de l'amplificateur différentiel (MD1 à MD5).

2.  Circuit oscillateur suivant la revendication 1, caractérisé par le fait qu'il est prévu, comme élément oscillant, un quartz oscillateur (Q).

3.  Circuit oscillateur suivant la revendication 1 ou 2, caractérisé par le fait que l'étage de sortie (I1 à I5) est relié à l'inverseur (M1,M2,T1) par l'intermédiaire d'un condensateur (T1).

4.  Circuit oscillateur suivant l'une des revendications 1 à 3, caractérisé par le fait que l'inverseur est constitué par un transistor MOS comportant une source de courant commandable disposée dans la voie du drain en tant que circuit de réglage.

5.  Circuit oscillateur suivant l'une des revendications 1 à 4, caractérisé par le fait que l'inverseur est constitué par deux transistors MOS complémentaires (M1,M2) branchés en montage push-pull.

6.  Circuit oscillateur suivant l'une des revendications 1 à 5, caractéisé par le fait qu'un transistor MOS (M1) est prévu comme circuit de réglage.

7.  Circuit oscillateur suivant la revendication 6, caractérisé par le fait qu'une diode (MD) est branchée, dans le sens passant, en parallèle avec le transistor MOS du circuit de réglage (MR).

8.  Circuit oscillateur suivant la revendication 6 ou 7, caractérisé par le fait qu'un condensateur (CO) est branché en parallèle avec le transistor MOS du circuit de réglage (MR).

9.  Circuit oscillateur suivant l'une des revendications 1 à 8, caractérisé par le fait qu'au moins un autre inverseur (I1 à I7) est prévu en tant qu'étage de sortie.

10. Circuit oscillateur suivant l'une des revendications 1 à 9, caractérisé par le fait qu'un condensateur (C6) est branché en parallèle avec la sortie de l'amplificateur différentiel (MD1 à MD5).

11. Circuit oscillateur suivant l'une des revendications 1 à 10, caractérisé par le fait que le circuit de régulation d'amplitude (AR) est relié à l'inverseur (M1,M2,T1) par l'intermédiaire d'un condensateur (C2).

12. Circuit oscillateur suivant l'une des revendications 1 à 11, caractérisé par le fait qu'il est prévu, comme redresseur de valeurs crêtes, respectivement un transistor MOS (MS1,MS2) comportant un système d'injection de courant (MS3,MS4), et branché selon un montage en source suiveuse et en aval duquel est branché un condensateur de lissage (C4,C5).

13. Circuit oscillateur suivant l'une des revendications 1 à 12, caractérisé par le fait que des première et seconde tensions auxiliaires sont produites à partir de la tension de référence (VR) à l'aide d'au moins un diviseur de tension (R2,R3,R4,R5).

14. Circuit oscillateur suivant l'une des revendications 1 à 13, caractérisé par le fait que les deux redresseurs de valeurs crêtes (MS1,MS3,C4; MS2,MS4,C5) sont identiques.

# FIG 1

# FIG 2